# EUROPEAN PATENT APPLICATION

(11) **EP 3 760 767 A1**
(43) Date of publication of application: **06.01.2021**
(21) Application number: 19883330.3
(22) Date of filing: 14.10.2019
(51) Int. Cl.: C30B 29/06, C30B 11/00, C30B 28/06

(54) **INGOT FURNACE FOR DIRECTIONAL SOLIDIFICATION GROWTH OF CRYSTALLINE SILICON AND APPLICATION**

(30) Priority: 08.05.2019 CN 201910379853
(71) Applicant: LDK Solar (Xinyu) Hi-Tech (Xinyu) Co., Ltd, Xinyu City, Jiangxi 338004 (CN)
(72) Inventor: CHEN, Xianhui, Xinyu City, Jiangxi 338004 (CN); ZOU, Guifu, Xinyu City, Jiangxi 338004 (CN); HE, Liang, Xinyu City, Jiangxi 338004 (CN); MAO, Wei, Xinyu City, Jiangxi 338004 (CN); LEI, Qi, Xinyu City, Jiangxi 338004 (CN)
(74) Representative: Viering, Jentschura & Partner mbB Patent- und Rechtsanwälte
(86) International application number: PCT/CN2019/110923
(87) International publication number: WO 2020/224186

(57) **Abstract**

A casting ingot furnace for directional solidification growth of crystalline silicon is provided. The casting ingot furnace includes a furnace body, a supporter, a protective plate, a thermal insulation cage, and a heater. The furnace body includes an upper furnace body and a lower furnace body engaged with the upper furnace body, and the lower furnace body defines a shaft hole at a bottom of the lower furnace body. The supporter includes a rotating shaft and a heat exchanger fixed to an end of the rotating shaft, and a crucible is disposed on the heat exchanger. The other end of the rotating shaft extends through the shaft hole to be coupled with a driving device disposed outside the lower furnace body, and the driving device is configured to drive the rotating shaft to rotate, whereby enabling the crucible to rotate. The rotating shaft defines a coolant circulating passage for introducing and circulating coolant to achieve circulating cooling of the rotating shaft. Uniform heating for the crucible is achieved through the casting ingot furnace, such that a problem that a large number of uneven growth interfaces exist on each side of the silicon ingot can be effectively resolved, red zones at a tail portion (for example, a lower end) of the silicon ingot are significantly reduced, thereby improving quality and yield of the silicon ingot. An application of the casting ingot furnace is also provided according to the present disclosure.

## Description

### CROSS-REFERENCE TO RELATED APPLICATION(S)

This application claims priority to Chinese Patent Application No. 201910379853.3, filed on May 8, 2019 to China National Intellectual Property Administration, and entitled "CASTING INGOT FURNACE FOR DIRECTIONAL SOLIDIFICATION GROWTH OF CRYSTALLINE SILICON AND APPLICATION THEREOF", the disclosure of which is hereby incorporated by reference in its entirety.

### TECHNICAL FIELD

The present disclosure relates to the technical field of casting crystalline silicon ingot furnaces, and particularly to a casting ingot furnace for directional solidification growth of crystalline silicon and an application thereof.

### BACKGROUND

Solar photovoltaic power generation is one of the most promising ways to utilize renewable energy. Among them, crystalline silicon solar cells continue to lead due to their high conversion efficiency and mature technology. The photoelectric conversion efficiency, attenuation rate, and cost of the crystalline silicon solar cells are closely related to the quality of the crystalline silicon used. This requires controlling various factors such as crystal phase, defects, impurities, and the like that affect the quality of the crystalline silicon during preparing the crystalline silicon.

At present, casting ingot furnaces are the main equipment for the production of the crystalline silicon in industry. However, a conventional casting ingot furnace generally has uneven heating, which causes an interface for an ingot single crystal growth to be uneven. In addition, there are a large number of uneven concavo-convex interfaces on four sides of a prepared silicon ingot, which causes a large number of red zones at a tail portion of the silicon ingot, which seriously affects a quality and yield of the silicon ingot.

### SUMMARY

In view of this, a casting ingot furnace for directional solidification growth of crystalline silicon and an application thereof are provided according to implementations of the present disclosure. Uniform heating for a crucible is achieved through the casting ingot furnace for directional solidification growth of crystalline silicon, such that a problem that a large number of uneven growth interfaces exist on each side of a silicon ingot can be effectively resolved, red zones at a tail portion (for example, a lower end) of the silicon ingot are significantly reduced, thereby improving the effect of removal of impurities from a silicon melt, and a quality and yield of the silicon ingot.

According to a first aspect of the present disclosure, a casting ingot furnace for directional solidification growth of crystalline silicon is provided. The casting ingot furnace includes a furnace body, a supporter, a protective plate, a thermal insulation cage, and a heater. The furnace body includes an upper furnace body and a lower furnace body engaged with the upper furnace body, and the lower furnace body defines a shaft hole at a bottom of the lower furnace body. The supporter includes a rotating shaft and a heat exchanger fixed to an end of the rotating shaft, and the heat exchanger is provided with a crucible. The other end of the rotating shaft extends through the shaft hole to be coupled with a driving device disposed outside the lower furnace body, and the driving device is configured to drive the rotating shaft to rotate, whereby enabling the crucible to rotate. The rotating shaft defines a coolant circulating passage for introducing and circulating coolant to achieve circulating cooling of the rotating shaft. The protective plate is disposed on an outer side wall of the crucible. The heater is disposed in the thermal insulation cage.

In an implementation, a coolant supply system is further disposed outside the lower furnace body, and the coolant supply system is in communication with the coolant circulating passage.

In an implementation, the casting ingot furnace further comprises a sealing device. The sealing device is used for sealing a gap between the rotating shaft and an inner wall of the shaft hole.

In an implementation, the sealing device includes a magnetic fluid sealing device, and the magnetic fluid sealing device is sleeved on the rotating shaft and fixed to the bottom of the lower furnace body.

In an implementation, the protective plate includes a side protective plate and a bottom protective plate. The bottom protective plate is sandwiched between a bottom of the crucible and the heat exchanger, and the bottom protective plate is provided with non-slip texture on a surface of the bottom protective plate.

In an implementation, the casting ingot furnace further includes multiple heat dissipation blocks. The multiple heat dissipation blocks are disposed adjacent to the heat exchanger, and each of the multiple heat dissipation blocks is fixed to the bottom of the lower furnace body via a support rod.

In an implementation, the rotating shaft is provided with a connecting plate at the end close to the heat exchanger. The connecting plate is provided with multiple connecting rods, and the multiple connecting rods are fixedly connected with the heat exchanger.

In an implementation, the heater includes a top heater and a side heater, the top heater is disposed above the crucible, and the side heater is disposed outside the outer side wall of the crucible. The side heater is free of contact with the crucible during a rotation of the crucible, and the side heater has a cross section in a shape of circular, square, or polygonal.

In an implementation, the thermal insulation cage includes a top thermal insulation plate, a side thermal insulation plate, and a bottom thermal insulation plate, which corporate to define a sealed chamber. At least one of the top thermal insulation plate, the side thermal insulation plate, or the bottom thermal insulation plate includes at least one thermal insulation layer.

According to the first aspect of the present disclosure, the casting ingot furnace for directional solidification growth of crystalline silicon is provided, heating for a rotary crucible is realized and heat distribution throughout the crucible is uniform, such that the problem that a large number of uneven growth interfaces exist on each side of the silicon ingot can be effectively resolved, the red zones at the tail portion (for example, the lower end) of the silicon ingot are significantly reduced, thereby improving the effect of removal of the impurities from the silicon melt, and the quality and yield of the silicon ingot. Circulating cooling in the casting ingot furnace for directional solidification growth of crystalline silicon is also realized, thereby improving heat dissipation performance of the casting ingot furnace to a certain extent. Isolation of the casting ingot furnace for directional solidification growth of crystalline silicon from the outside is also achieved by the magnetic fluid sealing device, thereby avoiding contamination by external impurities and instability of the temperature inside the casting ingot furnace.

According to a second aspect of the present disclosure, it is also provided an application of the casting ingot furnace according to the first aspect of the present disclosure in preparing single crystal silicon, polysilicon, or similar single crystal silicon.

In an implementation of the present disclosure, a method for preparing a silicon ingot is provided. The method for preparing the silicon ingot is carried out as follows.

The casting ingot furnace according to the first aspect of the present disclosure is provided, and a seed layer is laid in the crucible of the casting ingot furnace. Silicon material is placed on the seed layer. The silicon material in the crucible is melt into a silicon melt. When the seed layer is not completely melted, a thermal field is adjusted to achieve a supercooled state, crystals from the silicon melt start to grow on the seed layer. After the silicon melt is completely crystallized, a single crystal silicon ingot is obtained by cooling and annealing.

In another implementation of the present disclosure, the casting ingot furnace for directional solidification growth of crystalline silicon can also be used to prepare a polycrystalline silicon ingot or a single crystal silicon ingot.

The silicon ingot prepared with the casting ingot furnace according to the present disclosure has less red zones at the lower end of the silicon ingot and better semiconductor performance than conventional silicon ingots. The casting ingot furnace can improve the effect of removal of the impurities from the silicon melt, and thus the silicon ingot prepared has fewer impurities. In addition, the uneven concavo-convex interfaces on each surface of the silicon ingot prepared by the casting ingot furnace for directional solidification growth of crystalline silicon is significantly reduced, thereby significantly improving the yield of the silicon ingot, and also significantly reducing the production cost.

The advantages of the present disclosure will be clarified in the following description, and some of the advantages are explained in the description, or can be learned through the implementations of the present disclosure.

### BRIEF DESCRIPTION OF THE DRAWINGS

To describe the content of the present disclosure more clearly, it will be described in detail hereinafter with reference to the accompanying drawings and implementations.
FIG. 1 is a schematic cross-sectional structural view of a casting ingot furnace for directional solidification growth of crystalline silicon according to an implementation of the present disclosure;
FIG. 2 is a schematic partial transversal cross-sectional view of a casting ingot furnace for directional solidification growth of crystalline silicon according to an implementation of the present disclosure;
FIG. 3 is a schematic partial transversal cross-sectional view of a casting ingot furnace for directional solidification growth of crystalline silicon according to another implementation of the present disclosure;
FIG. 4 is a schematic partial transversal cross-sectional view of a casting ingot furnace for directional solidification growth of crystalline silicon according to another implementation of the present disclosure; and
FIG. 5 is a schematic cross-sectional structural view of a casting ingot furnace for directional solidification growth of crystalline silicon according to another implementation of the present disclosure.

### DETAILED DESCRIPTION OF ILLUSTRATED IMPLEMENTATIONS

The description below are preferred implementations of the present disclosure, and it is noted that various improvements and modifications can be made without departing from the principle of the present disclosure to those of ordinary skill in the art, and the improvements and the modifications are also considered as the protection scope of the present disclosure.

The terms "include", "comprise", and "have" as well as variations thereof in the specification, claims, and drawings of the present disclosure are intended to cover non-exclusive inclusion. For example, a process, method, system, product, or apparatus including a series of steps or units is not limited to the listed steps or units, on the contrary, it can optionally include other steps or units that are not listed; alternatively, other steps or units inherent to the process, method, product, or device can be included either.

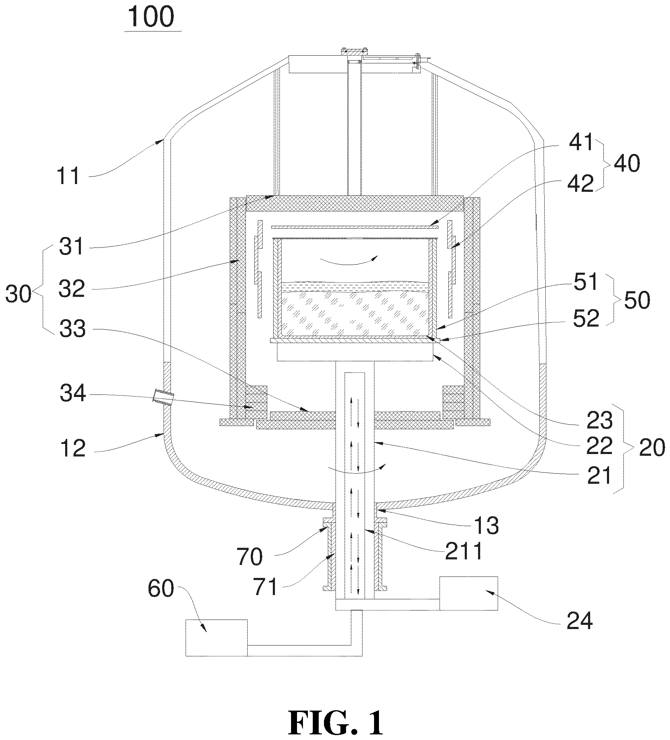

According to an implementation of the present disclosure, referring to FIG. 1, a casting ingot furnace 100 for directional solidification growth of crystalline silicon is provided. The casting ingot furnace 100 for directional solidification growth of crystalline silicon includes a furnace body 10, a supporter 20, a protective plate 50, a thermal insulation cage 30, and a heater 40. The furnace body 10 includes an upper furnace body 11 and a lower furnace body 12 engaged with the upper furnace body 11. The upper furnace body 11 defines a first opening, the lower furnace body 12 defines a second opening, and the first opening is opposite the second opening. The lower furnace body 12 defines a shaft hole 13 at a bottom of the lower furnace body 12. The supporter 20 (which also refers to a support plate) includes a rotating shaft 21 and a heat exchanger 22 fixed to an end of the rotating shaft 21, and the heat exchanger 22 is provided with a crucible 23. The other end of the rotating shaft 21 extends through the shaft hole 13 to be coupled with a driving device 24 disposed outside the lower furnace body 12, and the driving device 24 is configured to drive the rotating shaft 21 to rotate, whereby enabling the crucible 23 to rotate. The rotating shaft 21 defines a coolant circulating passage 211 for introducing and circulating coolant to achieve circulating cooling of the rotating shaft 21. The protective plate 50 is disposed on an outer side wall of the crucible 23. The heater 40 is disposed in the thermal insulation cage 30.

In an implementation, the thermal insulation cage 30 includes a top thermal insulation plate 31, a side thermal insulation plate 32, and a bottom thermal insulation plate 33. The top thermal insulation plate 31, the side thermal insulation plate 32, and the bottom thermal insulation plate 33, which corporate to define a sealed chamber of a thermal field. The crucible 23, the heat exchanger 22, the protective plate 50, and the heater 40 are all disposed in the thermal insulation cage 30.

In an implementation, at least one of the top thermal insulation plate 31, the side thermal insulation plate 32, or the bottom thermal insulation plate 33 includes at least one layer of a thermal insulation layer. For example, in an implementation of the present disclosure, each of the top thermal insulation plate 31, the side thermal insulation plate 32, and the bottom thermal insulation plate 33 includes two layers of the thermal insulation layers. In another implementation of the present disclosure, each of the top thermal insulation plate 31, the side thermal insulation plate 32, and the bottom thermal insulation plate 33 may include three layers of the thermal insulation layers.

In an implementation of the present disclosure, the top thermal insulation plate 31 and the side thermal insulation plate 32 are connected together to form a thermal insulation cover, and the thermal insulation cover is detachable from the bottom thermal insulation plate 33. Multiple thermal insulation strips 34 are arranged on an inner wall of an end of the side thermal insulation plate 32 close to the bottom thermal insulation plate 33. The thermal insulation strips 34 are used to cover and seal a gap defined by the side thermal insulation plate 32 and the bottom thermal insulation plate 33, thereby facilitating thermal insulation for the thermal insulation cage 30.

In the implementations of the present disclosure, the crucible 23 may be, but is not limited to, a conventional crucible. For example, the crucible may be a quartz crucible, a graphite crucible, or a ceramic crucible. In an implementations, a bottom and sidewall surfaces of the crucible may be coated with, but not limited to, a silicon nitride coating.

Further, the crucible 23 may have a cross section in a shape of circular, square, or polygonal. For example, the crucible 23 may be one of existing crucibles of various specifications, such as G5 crucible, G6 crucible, or G7 crucible. Since in the casting ingot furnace of the present disclosure, the crucible 23 is set to rotate by the driving device 24 and is heated by the heater 40, any of crucibles in various cross-sectional shapes can be uniformly heated in the casting ingot furnace of the present disclosure. In order to reduce waste of silicon ingot material, in an implementation, the crucible may be a crucible having a specified standard size or cross-sectional shape.

In an implementation, the heat exchanger 22 may be a directional solidification (DS) board. In another implementation, the heat exchanger 22 may be a DS block. The heat exchanger 22 is advantageous in achieving good heat dissipation at the bottom of the crucible 23, thereby facilitating directional growth of a silicon melt in the crucible 23.

In an implementation, the protective plate 50 includes a side protective plate 51 and a bottom protective plate 52, and the bottom protective plate 52 is sandwiched between the bottom of the crucible 23 and the heat exchanger 22. The protective plate 50 is in close contact with the crucible 23. A gap between the protective plate 50 and the crucible 23 may be, but is not limited to, filled with graphite soft felt. By filling the graphite soft felt, the protective plate 50 and the crucible 23 can be effectively attached together, such that more uniform heat distribution can be realized on a same horizontal plane of the crucible 23, and it is less prone to formation of blind spot regions where heating is insufficient and uneven.

In an implementation, the bottom protective plate 52 has good heat transfer performance and large friction with the crucible 23 and the heat exchanger 22, respectively.

In an implementation of the present disclosure, the bottom protective plate 52 is provided with a non-slip texture on a surface of the bottom protective plate. The non-slip texture includes non-slip grooves or non-slip protrusions. The anti-slip texture may have a regular shape or an irregular shape. The anti-slip texture can be evenly distributed on the entire surface of the bottom protective plate 52. Alternatively, the anti-slip texture may also be mainly distributed on a certain region of the bottom protective plate. The anti-slip texture is beneficial to increase the friction between the bottom protective plate 52 and the crucible 23 and the heat exchanger 22, such that the crucible 23 can be more easily driven to rotate by the rotating shaft 21.

In an implementation, the surface of the bottom protective plate 52 defines non-slip grooves, and each of the non-slip grooves may be a circular ring groove, a linear groove, a square groove, or a polygonal groove. Further, each of the non-slip grooves is filled with a thermally conductive material. By providing non-slip grooves and thermally conductive materials, on one hand, the friction between the bottom protective plate 52 and the crucible 23 and the heat exchanger 22 can be increased, such that the crucible 23 is better driven to rotate by the rotating shaft 21, and on the other hand, the heat transfer performance between the heat exchanger 22 and the crucible 23 can be further improved.

In an implementation of the present disclosure, the crucible 23 may also be provided with a non-slip texture on a bottom surface of the crucible 23. For example, as an implementation, the non-slip texture on the bottom surface of the crucible 23 includes non-slip grooves or non-slip protrusions. A surface of the heat exchanger 22 may also have a non-slip texture matching the non-slip texture of the bottom protective plate 52, so as to prevent relative sliding between the heat exchanger 22 and the bottom protective plate 52.

In an implementation of the present disclosure, fixing bolts or other components may be provided between the bottom protective plate 52 and the heat exchanger 22 to enhance the stability of a connection between the bottom protective plate 52 and the heat exchanger 22.

In an implementation of the present disclosure, the coolant circulating passage 211 of the rotating shaft 21 includes a water inlet pipe and a water outlet pipe. Both the rotating shaft 21 and the coolant circulating passage 211 have good thermal conductivity.

In an implementation of the present disclosure, a coolant supply system 60 is further disposed outside the lower furnace body 12, and the coolant supply system 60 is in communication with the coolant circulating passage 211. The coolant supply system 60 is configured to provide sufficient coolant for the coolant circulating passage 211. In an implementation, the coolant may be water. For example, as an implementation of the present disclosure, the coolant supply system 60 provides sufficient cooling water. The cooling water enters the coolant circulating passage 211 via the water inlet pipe of the coolant circulating passage 211 and then flows out of the coolant circulating passage 211 via the water outlet pipe. The coolant circulating passage 211 is used to realize a heat exchange and a temperature of the rotating shaft 21 is maintained within a preset range.

In an implementation, the rotating shaft 21 is further provided with a temperature monitoring component, and the temperature monitoring component is used to continuously monitor the temperature of the rotating shaft 21. When the temperature of the rotating shaft 21 exceeds a certain threshold, the temperature monitoring component may instruct to turn on the coolant supply system 60.

In an implementation of the present disclosure, the coolant supply system 60 may include existing conventional cooling water devices. For example, the coolant supply system 60 may include, but is not limited to, the assemblies such as a temperature controller, a water pump, a water tank, a cooling tower, and the like. The coolant supply system 60 may also include other existing devices, which are not listed in detail herein.

In an implementation, the driving device 24 may include a rotary motor or a servo motor. The driving device 24 is coupled with the rotating shaft 21 through a belt drive or a gear drive.

In an implementation, the driving device 24 is coupled with the rotating shaft 21 through the belt drive. According to the present disclosure, the driving device 24 enables a rotation of the rotating shaft 21 to be more stable through the belt drive. The belt drive also enables a rotation speed adjustment of the rotating shaft 21 to be more flexible and sensitive. Since the rotating shaft 21 can achieve cyclic cooling and maintain a low temperature, better protection for relevant components of the belt drive can be provided, and a belt can be prevented from being damaged by high temperature. For example, by adjusting the driving device 24, a belt drive assembly can immediately drive the rotating shaft 21 to rotate, thereby providing a wide speed range, high safety performance, and a low cost.

In an implementation, a rotation speed of the rotating shaft 21 can be adjusted according to the actual preparation process. In an implementation of the present disclosure, the rotating speed of the rotating shaft 21 falls within a range from 0 to 15 rpm. For example, as an implementation, the rotation speed of the rotating shaft 21 is 5 rpm, 10 rpm, or 15 rpm. The rotating shaft 21 may rotate during a heating process for preparing the silicon ingot, and may also rotate during other processes. The rotating shaft 21 may rotate at a uniform speed, an incrementing speed, or a decrementing speed.

In the implementations of the present disclosure, the casting ingot furnace for directional solidification growth of crystalline silicon further includes a sealing device. The sealing device is used for sealing a gap the rotating shaft 21 and an inner wall of the shaft hole 13.

In an implementation, the sealing device includes a magnetic fluid sealing device, and the magnetic fluid sealing device is sleeved on the rotating shaft 21 and fixed to the bottom of the lower furnace body 12. The magnetic fluid sealing device may further be provided with a protective sleeve, and the protective sleeve may be bellows 70. The magnetic fluid sealing device may be fixed to the bottom of the lower furnace body 12 via the protective sleeve.

As illustrated in FIG. 1, a flange structure is further provided, and the flange structure is fixed with the inner wall of the shaft hole 13 defined in the bottom of the lower furnace body 12. The bellows 70 is fixed with the flange structure. The magnetic fluid sealing device 71 is disposed in the bellows 70, and the rotating shaft 21 extends through the magnetic fluid sealing device 71 and the bellows 70.

In an implementation, the bellows 70 may be fixed with the inner wall of the shaft hole 13 by welding.

The magnetic fluid sealing device 71 of the present disclose includes a pole shoe, a magnet, and a magnetic fluid. Under an action of a magnetic field generated by the magnet, the magnetic fluid in a gap defined by the rotating shaft 21 and a top of the pole shoe is concentrated to form an O-ring, which seals the gap to achieve the purpose of sealing. The magnetic fluid sealing device 71 does not affect the rotation of the rotating shaft 21, and can also seal the shaft hole 13 of the lower furnace body 12. The magnetic fluid sealing device 71 of the present disclosure may be an existing product.

Due to the rotating shaft 21 of the present disclosure can achieve the cyclic cooling and maintain a low temperature, normal operation of the magnetic fluid sealing device 71 can be maintained, and thus, high temperature is not generated to affect the sealing performance of the magnetic fluid sealing device 71.

In an implementation, the top thermal insulation plate 31 defines an air inlet hole and an air outlet hole. The air inlet hole and the air outlet hole are beneficial to meet requirements for the air pressure and inert gas environment during the preparation of the silicon ingot.

In an implementation, a graphite cover plate is further disposed on the crucible 23. The graphite cover plate may define, but not limited to, a heat conduction hole or an air conduction hole. The air inlet hole and the air outlet hole of the top thermal insulation plate 31 may extend through the heater 40 and the graphite cover.

In an implementation of the present disclosure, the heater 40 includes a top heater 41 and a side heater 42. The top heater 41 is disposed above the crucible 23, and the side heater 42 is disposed outside the outer side wall of the crucible 23. In an implementation of the present disclosure, the side heater 42 is disposed in a space defined between the protective plate 50 and the thermal insulation cage 30. The top heater 41 and the side heater 42 is operable to heat the crucible 23, so as to melt the silicon material in the crucible 23 to form the silicon melt.

In an implementation of the present disclosure, the crucible 23 rotates relative to the heater 40, and when the crucible 23 rotates, the side heater 42 is free of contact with the crucible 23.

In an implementation, a distance between the side heater 42 and the crucible 23 is larger than 40 mm. For example, the distance between the side heater 42 and the crucible 23 may be 40 mm, or 45 mm, 50 mm, 55 mm, or 60 mm. In this implementation, a thickness of the protective plate 50 is not taken into consideration. When the protective plate 50 has a relative larger thickness, the distance between the side heater 42 and the crucible 23 can be adjusted appropriately.

In an implementation of the present disclosure, there is a certain distance between the side heater 42 and the crucible 23, and the side heater 42 does not affect rotations of the crucible 23, the protective plate 50, and the heat exchanger 22.

Further, the heater 40 may be in a symmetrical shape. In an implementation, the side heater 42 may be in a cylindrical shape or in an N prism shape, and N is a positive integer ranged from 4 to 20. The heater 40 in the N prism shape may be formed by splicing N heating plates, and each of the N heating plates includes multiple U-shaped heating resistance units. In an implementation, the heater 40 in the cylindrical shape includes multiple circular heating plates. When the heater 40 is energized, the heater 40 can heat the protective plate 50 and crucible 23 which are surrounded by the heater 40.

In an implementation, the side heater 42 has a cross section in a shape of circular, square, or polygonal. The polygonal shape may be a hexagonal shape, an octagonal shape, or the like. In an implementation of the present disclosure, the cross section of the side heater 42 may be in an octagonal shape.

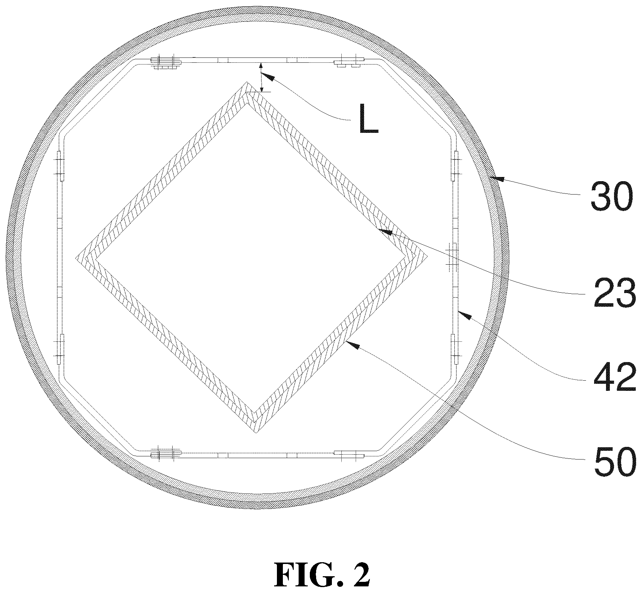

Referring to FIG. 2, in an implementation of the present disclosure, the thermal insulation cage 30 may have a cross section in a circular shape, and the side heater 42 may have a cross section in an octagonal shape. The side heater 42 includes four side edge heaters and four side corner heaters. Each side edge heater is connected with the side corner heater via a corner connecting piece. The crucible 23 has a cross section in a square shape, and a distance between the side heater 42 and the crucible 23 may be referred to be L.

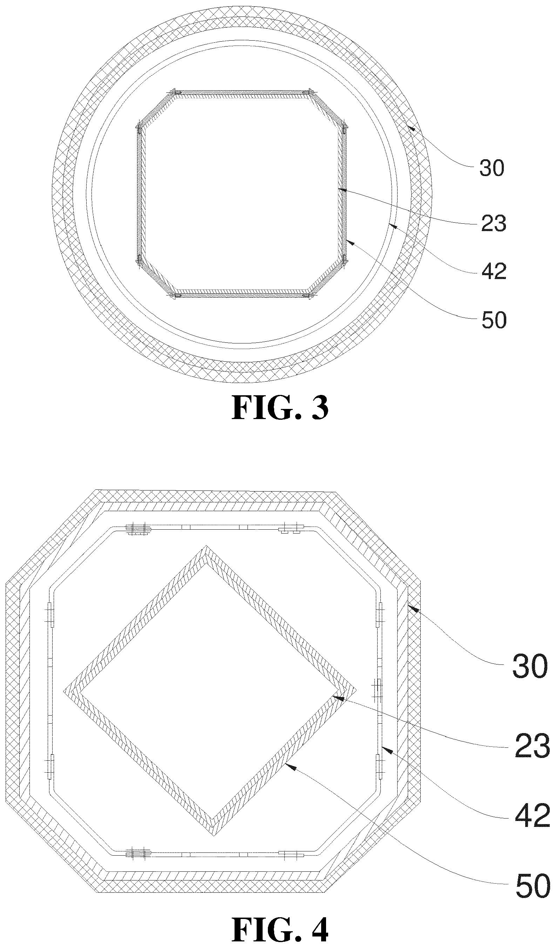

Referring to FIG. 3, in another implementation of the present disclosure, the thermal insulation cage 30 may have the cross section in a circular shape, the side heater 42 may also have the cross section in a circular shape, and the crucible 23 has the cross section in an octagonal shape.

Referring to FIG. 4, in another implementation of the present disclosure, the thermal insulation cage 30 may have the cross section in an octagonal shape, the side heater 42 may also have the cross section in an octagonal shape, and the crucible 23 has the cross section in a square shape.

According to another implementation of the present disclosure, a casting ingot furnace 200 for directional solidification growth of crystalline silicon is also provided. The casting ingot furnace 200 is different from the casting ingot furnace 100 for directional solidification growth of crystalline silicon grown in the following.

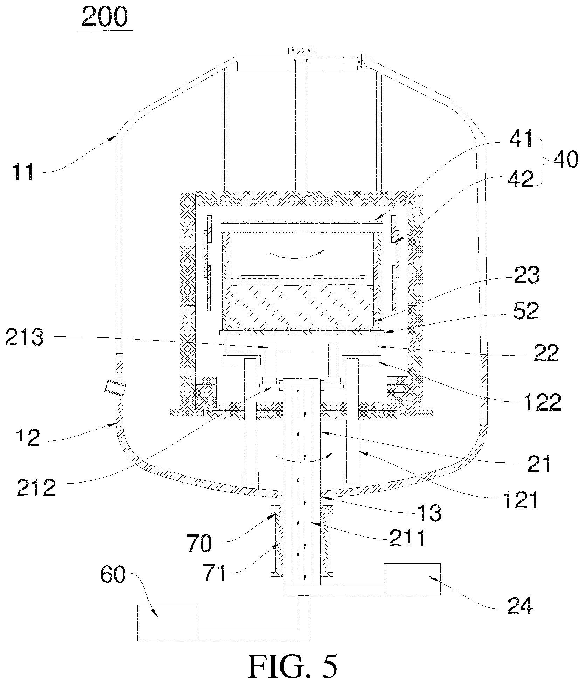

As illustrated in FIG. 5, a connecting plate 212 is disposed at an end of the rotating shaft 21 close to the heat exchanger 22, the connecting plate 212 is disposed with multiple connecting rods 213, and the connecting rods 213 are fixedly connected with the heat exchanger 22.

In an implementation, both the connecting plate 212 and the connecting rod 213 have good heat conduction performance and heat dissipation performance.

In the implementations of the present disclosure, the casting ingot furnace 200 further includes multiple heat dissipation blocks 122. The multiple heat dissipation blocks 122 are disposed adjacent to the heat exchanger 22, and each of the multiple heat dissipation blocks 122 is fixed to the bottom of the lower furnace body 12 through a support rod 121.

As illustrated in FIG. 5, the bottom of the lower furnace body 12 is further provided with the support rod 121. The end of the support rod 121 close to the heat exchanger 22 is disposed with the heat dissipation block 122, and the heat dissipation block 122 is disposed closed to a bottom surface of the heat exchanger 22. The heat dissipation block 122 has good heat dissipation performance, and can further perform heat dissipation for the heat exchanger 22. In an implementation, the heat dissipation block 122 may be made of the same material as the heat exchanger 22.

In an implementation, a distance between the heat dissipation block 122 and a side surface (for example, the bottom surface) of the heat exchanger 22 falls within a range from 50 mm to 100 mm. For example, the distance between the heat dissipation block 122 and the side surface of the heat exchanger 22 may be 50 mm, 60 mm, 70 mm, 80 mm, 90 mm, or 100 mm.

In an implementation, a size of the heat dissipation block 122 can be determined according to a size of the heat exchanger 22, and the heat dissipation block 122 does not affect the rotation of the heat exchanger 22.

Because it is difficult for a conventional casting silicon ingot furnace to provide uniform heating for the silicon material in the crucible 23, heat radiation is locally insufficient, resulting in a large number of uneven concavo-convex interfaces on four sides of a prepared silicon ingot, and a large number of red zones at a tail portion of the silicon ingot. According to the implementations of the present disclosure, the casting ingot furnace for directional solidification growth of crystalline silicon is provided, heating for the rotary crucible 23 is realized and heat distribution throughout the crucible 23 is uniform, such that the problem that a large number of uneven growth interfaces exist on each side of the silicon ingot can be effectively resolved, the red zones at the tail portion (for example, the lower end) of the silicon ingot are significantly reduced, thereby improving the quality and yield of the silicon ingot. Circulating cooling in the casting ingot furnace for directional solidification growth of crystalline silicon is also realized, thereby improving heat dissipation performance of the casting ingot furnace to a certain extent. Isolation of the casting ingot furnace for directional solidification growth of crystalline silicon from the outside is also achieved by the magnetic fluid sealing device 71, thereby avoiding contamination by external impurities and instability of the temperature inside the casting ingot furnace.

The casting ingot furnace for directional solidification growth of crystalline silicon according to the present disclosure can be used to prepare various types of silicon ingots, such as single crystal silicon ingots, polycrystalline silicon ingots, or similar single crystal silicon ingots.

In another implementation of the present disclosure, a method for preparing a silicon ingot is provided. The method is carried out as follows.

The casting ingot furnace for directional solidification growth of crystalline silicon is provided, and a seed layer is laid in the crucible of the casting ingot furnace. The silicon material is placed on the seed layer. The silicon material in the crucible is melt into a silicon melt. When the seed layer is not completely melted, a thermal field is adjusted to achieve a supercooled state, crystals from the silicon melt start to grow on the seed layer. After all the silicon melt is crystallized, a single crystal silicon ingot is obtained by annealing and cooling.

In an implementation, specific preparation processes of the single crystal silicon ingots, the polycrystalline silicon ingots, and the similar single crystal silicon ingots are different in some factors such as the silicon material, temperature, reaction duration, and the like.

Compared with the conventional casting ingot furnace, the silicon ingot prepared by the casting ingot furnace for directional solidification growth of crystalline silicon according to the present disclosure has much higher quality and yield. In addition, the method for preparing silicon ingot according to the present disclosure is simple, efficient, and low in cost, it can significantly reduce the red zones at the tail portion (for example, the lower end) of the silicon ingot and improve the yield of the silicon ingot.

In an implementation 1, a method for preparing a single crystal silicon ingot is carried out as follows.

The casting ingot furnace for directional solidification growth of crystalline silicon according to the implementations of the present disclosure is provided. The casting ingot furnace is provided with the crucible of G6 specification, and the crucible has an inner diameter of 1000 mm. The bottom and side walls of the crucible are coated with a silicon nitride coating, and a single crystal seed layer with a thickness of 20 mm is laid on the bottom of the crucible. The silicon material is placed on the seed layer, the coolant supply system 60 is turned on, the rotary motor is energized to rotate the crucible 23 which is heated by the heater 40, and the silicon material in the crucible 23 is melt into the silicon melt. When the seed layer is not completely melted, the thermal field is adjusted to achieve the supercooled state, the crystals from the silicon melt start to grow on the seed layer. After the silicon melt is completely crystallized, the single crystal silicon ingot is obtained by annealing and cooling.

### Implementations of Effects

The single crystal silicon ingot prepared according to the method described in implementation 1 and the silicon ingot prepared using a conventional casting crystalline silicon ingot furnace and under the same operation process are respectively squared into silicon blocks and tested for appearance and minority lifetime.

The results show that the surfaces and peripheral edges of the silicon ingot prepared by the conventional casting ingot furnace have large and small uneven interfaces, while the surfaces of the single crystal silicon ingot prepared by the casting ingot furnace according to the present disclosure are flat. In addition, the red zone at the tail portion of the single crystal silicon ingot prepared by the conventional casting ingot furnace has a relatively large height, while the red zone at the tail portion of the single crystal silicon ingot prepared by the casting ingot furnace according to the present disclosure has a relative small height, and have a cleaner minority map of the silicon block. Thus, the single crystal silicon ingot prepared by the casting ingot furnace according to the present disclosure has a better quality. Compared with the single crystal silicon ingot prepared by the conventional casting ingot furnace, the yield of the single crystal silicon ingot prepared by the method according to the implementation 1 of the present disclosure is increased by more than 8%.

It is be noted that, according to the disclosure and illustration of the foregoing description, those skilled in the art may also make variations and modifications to the foregoing implementations. Therefore, the present disclosure is not limited to the implementations disclosed and described above, and some equivalent modifications and variations for the present disclosure should also be considered to fall into the protection scope of claims of the present disclosure. In addition, although some specific terms are used in this specification, these terms are only for convenience of illustration and cannot be understood as limitations on the present disclosure.

## Claims

1. A casting ingot furnace for directional solidification growth of crystalline silicon, comprising:
a furnace body comprising an upper furnace body and a lower furnace body engaged with the upper furnace body, wherein the lower furnace body defines a shaft hole at a bottom of the lower furnace body;
a supporter comprising a rotating shaft and a heat exchanger fixed to an end of the rotating shaft, wherein the heat exchanger is provided with a crucible, the other end of the rotating shaft extends through the shaft hole to be coupled with a driving device disposed outside the lower furnace body, wherein the driving device is configured to drive the rotating shaft to rotate, whereby enabling the crucible to rotate, and wherein the rotating shaft defines a coolant circulating passage for introducing and circulating coolant to achieve circulating cooling of the rotating shaft;
a protective plate disposed on an outer side wall of the crucible;
a thermal insulation cage; and
a heater disposed in the thermal insulation cage.

2. The casting ingot furnace of claim 1, wherein a coolant supply system is further disposed outside the lower furnace body, and the coolant supply system is in communication with the coolant circulating passage.

3. The casting ingot furnace of claim 1, further comprising a sealing device for sealing a gap between the rotating shaft and an inner wall of the shaft hole.

4. The casting ingot furnace of claim 3, wherein the sealing device comprises a magnetic fluid sealing device, the magnetic fluid sealing device is sleeved on the rotating shaft and fixed to the bottom of the lower furnace body.

5. The casting ingot furnace of claim 1, wherein the protective plate comprises a side protective plate and a bottom protective plate, wherein the bottom protective plate is sandwiched between a bottom of the crucible and the heat exchanger, and the bottom protective plate is provided with non-slip texture on a surface of the bottom protective plate.

6. The casting ingot furnace of claim 1, further comprising a plurality of heat dissipation blocks, wherein the plurality of heat dissipation blocks are disposed adjacent to the heat exchanger, and each of the plurality of heat dissipation blocks is fixed to the bottom of the lower furnace body via a support rod.

7. The casting ingot furnace of claim 1, wherein the rotating shaft is provided with a connecting plate at the end close to the heat exchanger, the connecting plate is provided with a plurality of connecting rods, and the plurality of connecting rods are fixedly connected with the heat exchanger.

8. The casting ingot furnace of any of claims 1 to 7, wherein the heater comprises a top heater and a side heater, wherein the top heater is disposed above the crucible, the side heater is disposed outside the outer side wall of the crucible, and the side heater is free of contact with the crucible during a rotation of the crucible, and wherein the side heater has a cross section in a shape of circular, square, or polygonal.

9. The casting ingot furnace of any of claims 1 to 7, wherein the thermal insulation cage comprises a top thermal insulation plate, a side thermal insulation plate, and a bottom thermal insulation plate, which corporate to define a sealed chamber, and wherein at least one of the top thermal insulation plate, the side thermal insulation plate, or the bottom thermal insulation plate comprises at least one thermal insulation layer.

10. An application of the casting ingot furnace of any of claims 1 to 9 in preparing single crystal silicon, polycrystalline silicon, or similar single crystal silicon.
